# EUROPEAN PATENT APPLICATION

(11) **EP 4 769 370 A1**
(43) Date of publication of application: **01.07.2026**
(21) Application number: 25226360.3
(22) Date of filing: 22.12.2025
(51) Int. Cl.: G09F 9/30, G06F 1/16

(54) **DISPLAY DEVICE**

(30) Priority: 27.12.2024 KR 20240198353
(71) Applicant: LG Electronics Inc., Yeongdeungpo-gu Seoul 07336 (KR)
(72) Inventor: AN, Sungyul, 07796 Seoul (KR); IM, Jongyun, 07796 Seoul (KR); CHO, Doochan, 07796 Seoul (KR); JEON, Junyoung, 07796 Seoul (KR)
(74) Representative: Vossius & Partner Patentanwälte Rechtsanwälte mbB

(57) **Abstract**

A display device may include: a flexible plate; a flexible display panel coupled to the flexible plate; a first side frame coupled to a rear first side of the flexible plate; a second side frame coupled to a rear second side of the flexible plate; a center frame coupled to the flexible plate between the first side frame and the second side frame; a first arm extending from the center frame to the first side frame, and rotatably coupled to the first side frame; a second arm extending from the center frame to the second side frame, and rotatably coupled to the second side frame; and a driving module on the center frame and configured to actuate slidable and moveable first and second rods in and out to slidably extend and retract the first arm and the second arm, respectively.

## Description

### CROSS-REFERENCE TO RELATED APPLICATION

This application claims priority to Korean Patent Application No. 10-2024-0198353, filed in the Republic of Korea on December 27, 2024, the disclosure of which is incorporated herein by reference.

### BACKGROUND OF THE INVENTION

### Field of the invention

The present disclosure relates to a display device. More particularly, the present disclosure relates to a display device capable of changing the curvature of a display panel.

### Description of the Related Art

As the information society develops, the demand for display devices is also increasing in various forms. In response to this, various display devices such as Liquid Crystal Display Device (LCD), Plasma Display Panel (PDP), Electroluminescent Display (ELD), Vacuum Fluorescent Display (VFD), and Organic Light Emitting Diode (OLED) have been researched and used in recent years.

Among them, an OLED panel may display images by depositing an organic layer that may emit light autonomously on a substrate on which a transparent electrode is formed. OLED panel is not only thin but also has flexible characteristics. Much research has been conducted on the structural characteristics of display device equipped with such an OLED panel.

### SUMMARY OF THE INVENTION

It is an objective of the present disclosure to solve the above and other problems.

Another object of the present disclosure may be to provide a structure that can freely change the curvature of a display panel.

Another object of the present disclosure may be to provide a mechanism that can freely change the curvature of a display panel.

Another object of the present disclosure may be to provide a structure for synchronizing the rotation of arms that bend or unfold a display panel.

Another object of the present disclosure may be to provide a structure for pushing or pulling arms while an actuator is lifted.

Another object of the present disclosure may be to provide a structure for minimizing vibration and noise of an actuator.

In accordance with an aspect of the present disclosure, a display device may include: a flexible display panel; a flexible plate which is positioned behind the display panel, and to which the display panel is coupled; a first side frame adjacent to a first side of the plate and coupled to a rear of the plate; a second side frame adjacent to a second side of the plate which is opposite to the first side of the plate and coupled to the rear of the plate; a first arm extending in a direction intersecting with the first side of the plate, and rotatably coupled to the first side frame; a second arm extending in a direction intersecting with the second side of the plate, and rotatably coupled to the second side frame; and a driving module positioned between the first arm and the second arm, and rotating the first arm and the second arm.

### BRIEF DESCRIPTION OF THE DRAWINGS

The above and other objects, features and advantages of the present invention will be more apparent from the following detailed description in conjunction with the accompanying drawings, in which:

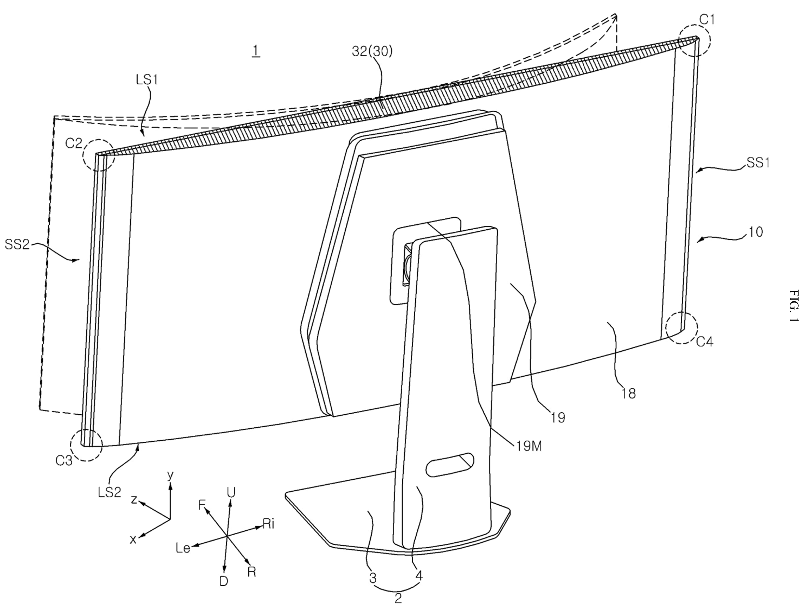

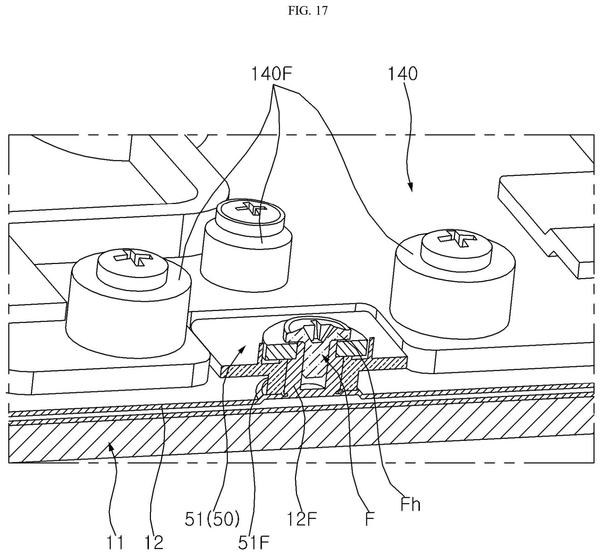

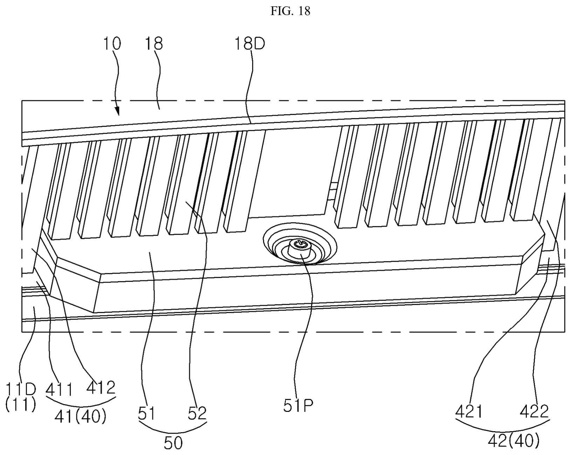

FIGS. 1 to 22 are diagrams illustrating examples of a display device according to embodiments of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are only used to distinguish one element from another.

When an element is referred to as being "coupled," "fixed," "mounted," "connected," "linked," etc. to another element, there may be intervening elements present. When an element is referred to as being "directly coupled," "directly fixed," "directly mounted," "directly connected," "directly linked" etc. to another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

The direction indications of up U, down D, left Le, right Ri, front F, and rear R shown in the drawings are only for the convenience of explanation, and the technical concepts disclosed in this specification are not limited thereby.

Referring to FIG. 1, a display device 1 may include a display 10. The display 10 displays an image in a forward direction. The display 10 may be referred to as a display unit 10 or a display head 10.

The display 10 may include a first long side LS1, a second long side LS2 opposite to the first long side LS1, a first short side SS1 adjacent to the first long side LS1 and the second long side LS2, and a second short side SS2 opposite to the first short side SS1. Meanwhile, for convenience of explanation, it is illustrated that the lengths of the first and second long sides LS1 and LS2 are longer than the lengths of the first and second short sides SS1 and SS2, but it may be possible that the lengths of the first and second long sides LS1 and LS2 are approximately the same as the lengths of the first and second short sides SS1 and SS2.

The direction parallel to the long sides LS1, LS2 of the display 10 may be referred to as a left-right direction. The direction parallel to the short sides SS1, SS2 of the display 10 may be referred to as an up-down direction. The direction perpendicular to the long sides LS1, LS2 and short sides SS1, SS2 of the display 10 may be referred to as a front-rear direction.

The direction in which the display 10 displays an image may be referred to as a front (F, z), and the opposite direction may be referred to as a rear R. The first short side SS1 side may be referred to as a right Ri. The second short side SS2 side may be referred to as a left (Le, x). The first long side LS1 side may be referred to as an upper side (U, y). The second long side LS2 side may be referred to as a lower side D.

The first long side LS1, the second long side LS2, the first short side SS1, and the second short side SS2 may be referred to as an edge of the display 10. The point where the first long side LS1, the second long side LS2, the first short side SS1, and the second short side SS2 meet each other may be referred to as a corner.

A point where the first short side SS1 and the first long side LS1 meet may be referred to as a first corner C1. A point where the first long side LS1 and the second short side SS2 meet may be referred to as a second corner C2. A point where the second short side SS2 and the second long side LS2 meet may be referred to as a third corner C3. A point where the second long side LS2 and the first short side SS1 meet may be referred to as a fourth corner C4.

A stand 2 of the display device 1 may be coupled to the display 10. The stand 2 may include a base 3 and a column 4. The base 3 may be placed on a table or a flat floor. The column 4 may be extended from the base 3. The column 4 may be coupled to the rear of the display 10. Accordingly, the stand 2 may support the display 10.

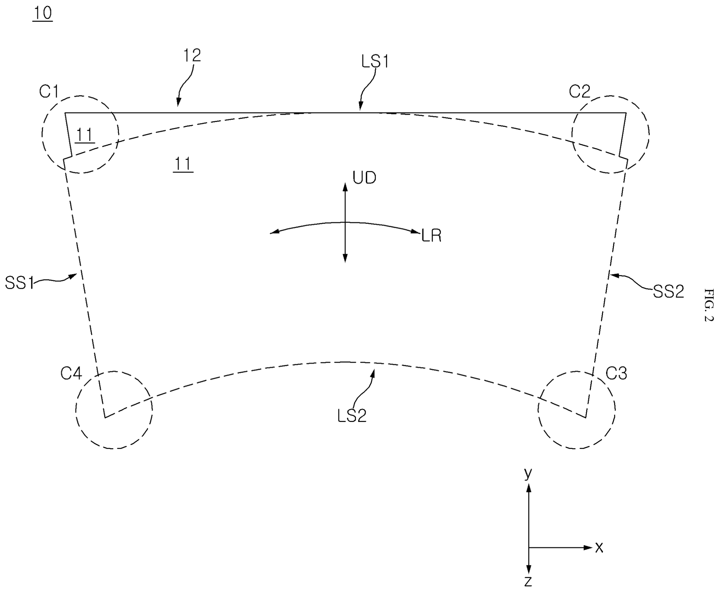

Referring to FIG. 2, a plate 12 of the display 10 may be flexible. For example, the plate 12 may be a metal plate. The plate 12 may be referred to as a flexible plate 12, a frame 12, or a base 12. A display panel 11 of the display 10 may be coupled to the front of the plate 12. The display panel 11 may be flexible. For example, the display panel 11 may be an Organic Light Emitting Diode (OLED) panel.

The display panel 11 may form the front surface of the display 10, and display an image. The display panel 11 may divide an image into a plurality of pixels and display an image by adjusting the color, brightness, and saturation for each pixel. The display panel 11 may generate light corresponding to the color of red, green, or blue according to a control signal.

The display 10 may have a variable curvature. The left side and the right side of the display 10 may move in a forward direction. For example, when viewing an image from the front of the display 10, the display 10 may be concavely curved. The plate 12 may be bent with the same curvature as the display panel 11. The display panel 11 may be bent in correspondence with the curvature of the plate 12.

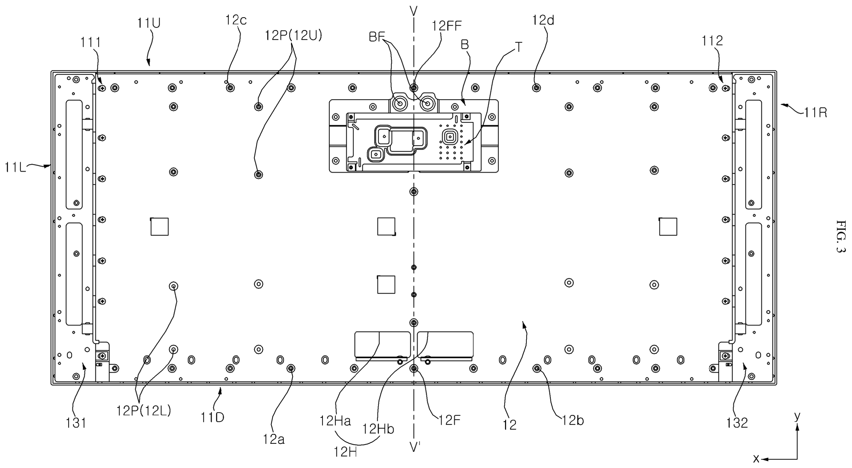

Referring to FIG. 3, a source PCB 11a may be adjacent to the lower side 11D of the display panel 11, and may extend along the lower side 11D. The source PCB 11a may be positioned on the rear surface of the display panel 11. The source PCB 11a may be electrically connected to the display panel 11 via a cable 11b such as Chip On Film (COF). The cables 11b may be arranged along the source PCB 11a.

A first side plate 131 may be adjacent to the left side 11L of the display panel 11, and may extend along the left side 11L. The first side plate 131 may be coupled to the rear surface of the display panel 11.

A second side plate 132 may be adjacent to the right side 11R of the display panel 11, and may extend along the right side 11R. The second side plate 132 may be coupled to the rear surface of the display panel 11.

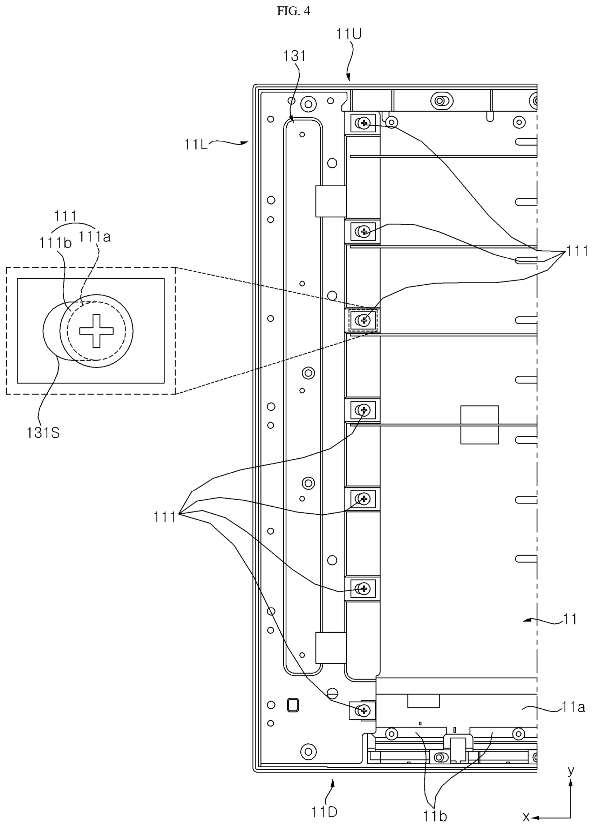

Referring to FIG. 4, a first side pin 111 may protrude from the rear surface of the display panel 11, and may be inserted into a first front slot 131S of the first side plate 131. The first side pins 111 may be arranged along the first side plate 131. Each of the first side pins 111 may be inserted into each of the first front slots 131S. The width of the first front slot 131S may be larger than the diameter of a body 111a of the first side pin 111 penetrating the first front slot 131S. If the display panel 11 is flat, the first side pin 111 may be adjacent to the right distal end of the first front slot 131S.

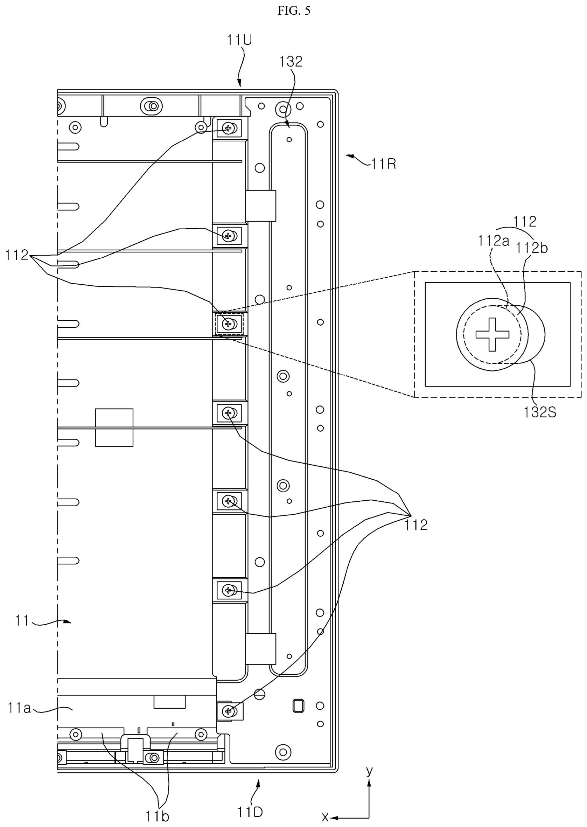

Referring to FIG. 5, a second side pin 112 may protrude from the rear surface of the display panel 11, and may be inserted into a second front slot 132S of the second side plate 132. The second side pins 112 may be arranged along the second side plate 132. Each of the second side pins 112 may be inserted into each of the second front slots 132S. The width of the second front slot 132S may be larger than the diameter of a body 112a of the second side pin 112 penetrating the second front slot 132S. When the display panel 11 is flat, the second side pin 112 may be adjacent to the left distal end of the second front slot 132S.

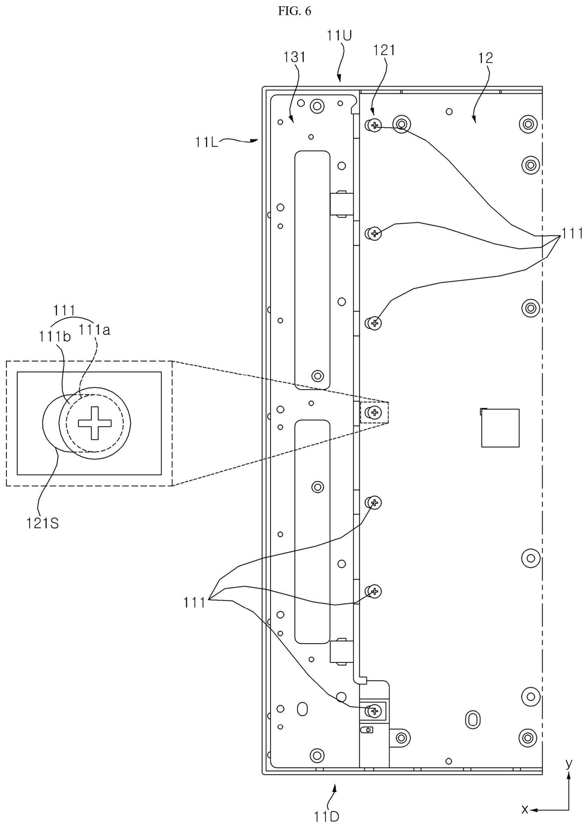

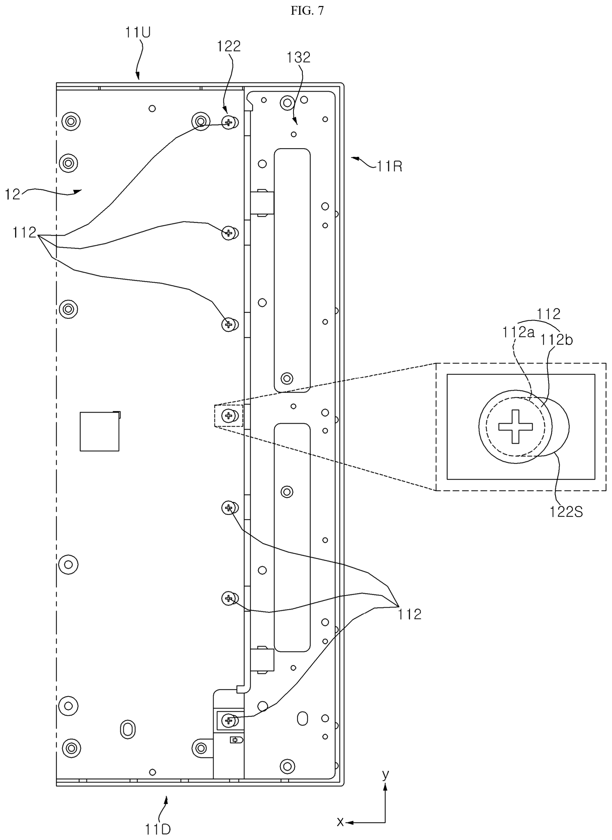

Referring to FIGS. 6 and 7, the plate 12 may be positioned between the first side plate 131 and the second side plate 132, and may be positioned on the rear surface of the display panel 11. The plate 12 may cover the source PCB 11a (see FIGS. 4 and 5) and the cables 11b (see FIGS. 4 and 5) on the rear surface of the display panel 11.

Referring to FIG. 6, a first portion 121 of the plate 12 may cover a portion (see FIG. 4) of the first side plate 131 where the first front slots 131S are formed. The first side pin 111 may be inserted into a first rear slot 121S of the plate 12. The first rear slots 121S may be aligned with the first front slots 131S. The width of the first rear slot 121S may be larger than the diameter of the body 111a of the first side pin 111 penetrating the first rear slot 121S. If the display panel 11 is flat, the first side pin 111 may be adjacent to the right distal end of the first rear slot 121S.

Referring to FIG. 7, a second portion 122 of the plate 12 may cover a portion (see FIG. 5) of the second side plate 132 where the second front slots 132S are formed. The second side pin 112 may be inserted into a second rear slot 122S of the plate 12. The second rear slots 122S may be aligned with the second front slots 132S. The width of the second rear slot 122S may be larger than the diameter of the body 112a of the second side pin 112 penetrating the second rear slot 122S. If the display panel 11 is flat, the second side pin 112 may be adjacent to the left distal end of the second rear slot 122S.

The rear surface of the plate 12 may be engaged with a head 111b of the first side pin 111 and a head 112b of the second side pin 112. Accordingly, the plate 12 and the first and second side plates 131, 132 may be coupled to the display panel 11.

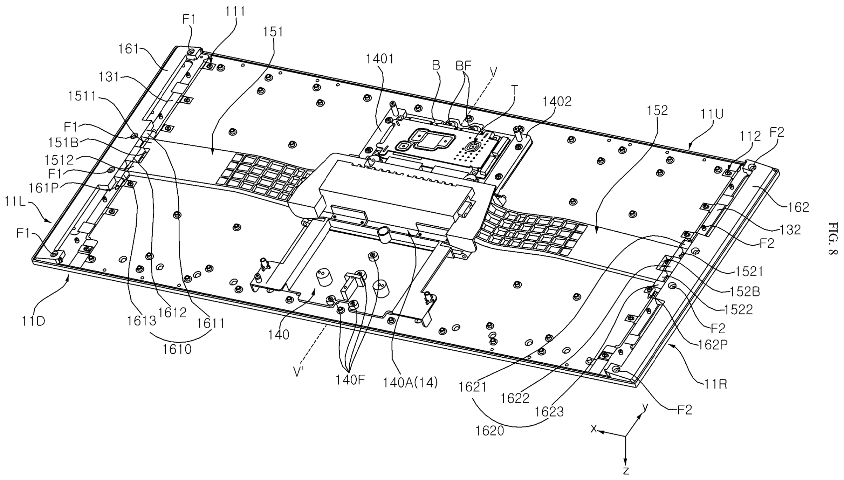

Referring to FIG. 8, a bracket B may be positioned on a vertical line VV' passing through the central portion of the plate 12. The bracket B may be positioned at the rear of the plate 12. Fastening members such as a screw may be fastened to the plate 12 by penetrating fixing parts BF (see FIG. 3) of the bracket B. The fixing parts BF of the bracket B may be positioned on the vertical line VV' or on less than a certain distance Da from the vertical line VV'. In other words, the central portion of the bracket B may be fixed to the central portion of the plate 12.

A timing controller board T may be coupled to the rear of the bracket B. The timing controller board T may be adjacent to the central portion of the upper side of the plate 12. Alternatively, the timing controller board T may be adjacent to the central portion of the lower side of the plate 12. A cable such as a flexible flat cable (FFC) may be electrically connected to the timing controller board T. The cable may be electrically connected to the source PCB 11a (see FIGS. 4 and 5) through the hole 12H (see FIG. 3) formed in the plate 12. Accordingly, the timing controller board T may provide a video signal to the display panel 11.

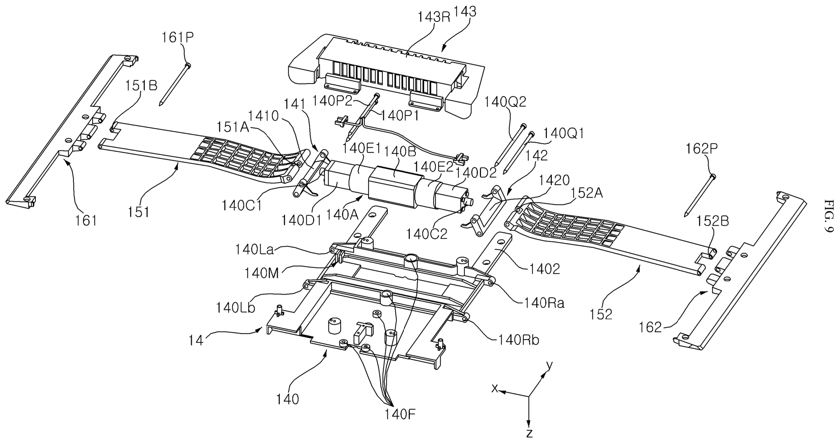

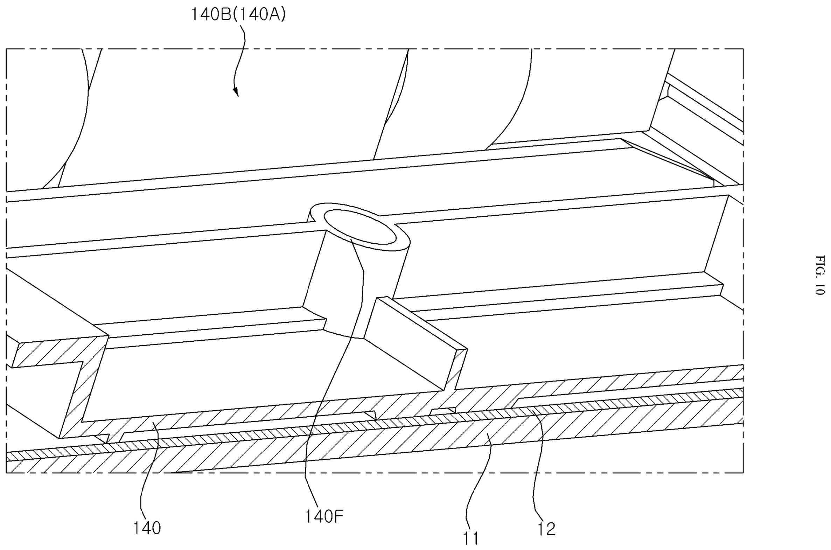

Referring to FIGS. 9 and 10, a driving module 14 may include a frame 140, an actuator 140A, a first link 141, and a second link 142.

The frame 140 may be positioned on a vertical line VV' passing through the central portion of the plate 12. The frame 140 may be positioned at the rear of the plate 12. Fastening members such as screws may be fastened to the plate 12 by penetrating the fixing parts 140F of the frame 140. The fixing parts 140F may be positioned on the vertical line VV' or on less than a certain distance Db from the vertical line VV'. In other words, the central portion of the frame 140 may be fixed to the central portion of the plate 12. The outer part of the frame 140 may be spaced rearward from the plate 12 (see Ds of FIG. 10). The distance Ds between the outer part of the frame 140 and the plate 12 may increase as the plate 12 is bent. The frame 140 may be referred to as a center frame 140.

Meanwhile, a first portion 1401 of the frame 140 may be fixed to the bracket B adjacent to the left side of the bracket B. A second portion 1402 of the frame 140 may be fixed to the bracket B while being adjacent to the right side of the bracket B.

The actuator 140A may include a motor 140B, a first rod 140C1, and a second rod 140C2. The actuator 140A may be referred to as a linear actuator 140A.

The motor 140B may be an electric motor. The rotation direction, rotation angle, and rotation speed of the rotation shaft of the motor 140B may be adjusted. The motor 140B may be a step motor.

The first rod 140C1 may be positioned in the first housing 140D1 on the left side of the motor 140B. In response to the driving of the motor 140B, the first rod 140C1 may move to the left and protrude from the first housing 140D1, or may move to the right and be inserted into the first housing 140D1. For example, the first rod 140C1 may be coupled to a first lead screw fixed to a first rotation shaft of the motor 140B, and may linearly reciprocate along the first lead screw. A first reducer 140E1 may be connected to the first rotation shaft of the motor 140B. The first reducer 140E1 may reduce the rotation speed of the first rotation shaft of the motor 140B (i.e., increase the torque) and transmit to the first lead screw.

The second rod 140C2 may be positioned in the second housing 140D2 on the right side of the motor 140B. In response to the driving of the motor 140B, the second rod 140C2 may be moved to the right and protruded from the second housing 140D2, or may be moved to the left and inserted into the second housing 140D2. For example, the second rod 140C2 may be coupled to a second lead screw fixed to a second rotation shaft of the motor 140B and may linearly reciprocate along the second lead screw. A second reducer 140E2 may be connected to the second rotation shaft of the motor 140B. The second reducer 140E2 may reduce the rotation speed of the second rotation shaft of the motor 140B (i.e., increase the torque) and transmit to the second lead screw.

Accordingly, the actuator 140A may move the first and second rods 140C1, 140C2 by using a single motor 140B. The moving directions of the first and second rods 140C1, 140C2 may be opposite to each other. The moving distances of the first and second rods 140C1, 140C2 may be the same. For example, the first and second rotation shafts may be the same shaft.

A first arm 151 may be extended long. The first arm 151 may be referred to as a first wing 151. The first arm 151 may be extended from the first rod 140C1 toward the first side plate 131. The width of the first arm 151 may be smaller than the length of the first arm 151. At least a portion of the first arm 151 may be curved. Intersecting ribs (not shown) may be formed on the rear surface of the first arm 151. One side of the first arm 151 may be coupled to the first rod 140C1. The other side of the first arm 151 may be coupled to a first side frame 161. The first side frame 161 may extend in a direction intersecting with the first arm 151. The first side frame 161 may extend along the first side plate 131. The first side frame 161 may be coupled to the rear of the first side plate 131.

The first link 141 may be adjacent to the first rod 140C1. The first link 141 may connect the frame 140 and the first arm 151.

A second arm 152 may be extended long. The second arm 152 may be referred to as a second wing 152. The second arm 152 may be extended from the second rod 140C2 toward the second side plate 132. The width of the second arm 152 may be smaller than the length of the second arm 152. At least a portion of the second arm 152 may be curved. Intersecting ribs (not shown) may be formed on the rear surface of the second arm 152. One side of the second arm 152 may be coupled to the second rod 140C2. The other side of the second arm 152 may be coupled to the second side frame 162. The second side frame 162 may extend in a direction intersecting with the second arm 152. The second side frame 162 may extend along the second side plate 132. The second side frame 162 may be coupled to the rear of the second side plate 132.

The second link 142 may be adjacent to the second rod 140C2. The second link 142 may connect the frame 140 and the second arm 152.

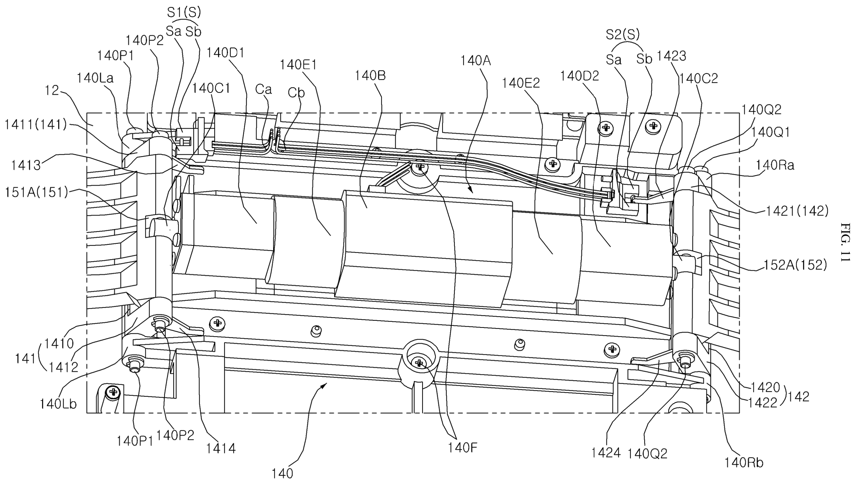

Referring to FIG. 11, the actuator 140A may be positioned at the rear of the frame 140. The first rod 140C1 of the actuator 140A may be adjacent to the left side of the frame 140. The second rod 140C2 of the actuator 140A may be adjacent to the right side of the frame 140.

A pair of first holders 140La, 140Lb may protrude from the left side of the frame 140, and may be spaced apart from each other along the left side.

The first link 141 may include a first link base 1410 and a pair of first wings 1411, 1412. The first link base 1410 may extend along the left side of the frame 140, and may be positioned between the pair of first holders 140La, 140Lb. A first front shaft 140P1 may penetrate the pair of first holders 140La, 140Lb and the first link base 1410. The first link 141 may be coupled to the pair of first holders 140La, 140Lb so as to be rotatable (pivotable) about the first front shaft 140P1. The pair of first wings 1411, 1412, wings may protrude from the first link base 1410, and intersect with the first link base 1410. The first wing 1411 may be adjacent to one end of the first link base 1410, and the second wing 1412 may be adjacent to the other end of the first link base 1410.

One end of the first arm 151 may be positioned between the pair of first wings 1411, 1412. A first groove 151A may be formed at one end of the first arm 151. The first rod 130C1 may be inserted into the first groove 151A. A first rear shaft 140P2 may penetrate the pair of first wings 1411, 1412, the first arm 151, and the first rod 130C1. The first arm 151 may be coupled to the first link 141 so as to be rotatable about the first rear shaft 140P2. The first arm 151 may be coupled to the first rod 130C1 so as to be rotatable about the first rear shaft 140P2. In response to the movement of the first arm 151, the first arm 151 and the first link 141 may be rotated.

A pair of second holders 140Ra, 140Rb may protrude from the right side of the frame 140, and may be spaced apart from each other along the right side.

The second link 142 may include a second link base 1420 and a pair of second wings 1421, 1422. The second link base 1420 may extend along the right side of the frame 140, and may be positioned between the pair of second holders 140Ra, 140Rb. A second front shaft 140Q1 may penetrate the pair of second holders 140Ra, 140Rb and the second link base 1420. The second link 142 may be coupled to the pair of second holders 140Ra, 140Rb so as to be rotatable (pivotable) about the second front shaft 140Q1. The pair of second wings 1421, 1422 may protrude from the second link base 1420 and intersect with the second link base 1420. The second wing 1421 may be adjacent to one end of the second link base 1420, and the second wing 1422 may be adjacent to the other end of the second link base 1420.

One end of the second arm 152 may be positioned between the pair of second wings 1421, 1422. A second groove 152A may be formed in one end of the second arm 152. The second rod 130C2 may be inserted into the second groove 152A. A second rear shaft 140Q2 may penetrate the pair of second wings 1421, 1422, the second arm 152, and the second rod 130C2. The second arm 152 may be coupled to the second link 142 so as to be rotatable about the second rear shaft 140Q2. The second arm 152 may be coupled to the second rod 130C2 so as to be rotatable about the second rear shaft 140Q2. In response to the movement of the second arm 152, the second arm 152 and the second link 142 may be rotated.

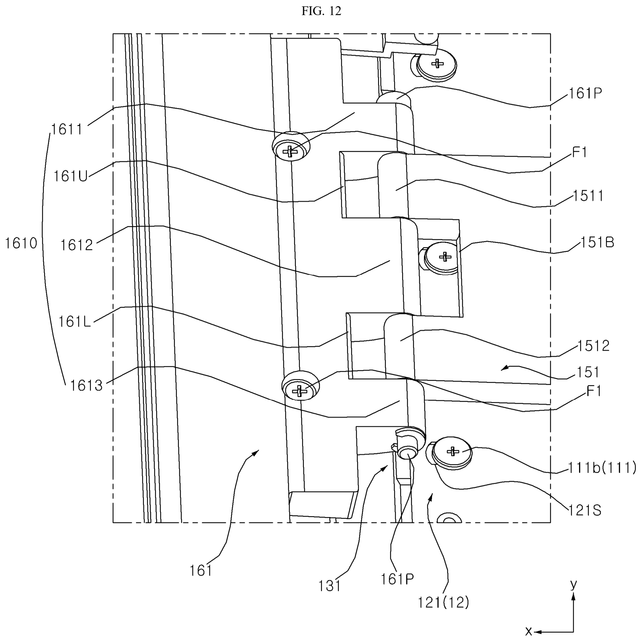

Referring to FIG. 12 together with FIG. 8, the first side frame 161 may extend along the left side 11L of the display panel 11, and the left side of the first side frame 161 may be adjacent to the left side 11L. The second side frame 162 may extend along the right side 11R of the display panel 11, and the right side of the second side frame 162 may be adjacent to the right side 11R.

A first fastening member F1 may fix the first side frame 161 to the first side plate 131. The first fastening members F1 may be arranged along the first side frame 161. The first fastening member F1 may be a screw. A second fastening member F2 may fix the second side frame 162 to the second side plate 132. The second fastening members F2 may be arranged along the second side frame 162. The second fastening member F2 may be a screw.

A first holder 1610 may protrude from the first side frame 161 toward the first arm 151. The first holder 1610 may be formed at a central portion of the right side of the first side frame 161. The first holder 1610 may include parts 1611, 1612, 1613 that are spaced apart from each other. An upper groove 161U may be formed between an upper part 1611 and a middle part 1612. A lower groove 161L may be formed between the middle part 1612 and a lower part 1613. A third groove 151B may be formed at the other end of the first arm 151. The middle part 1612 may be inserted into the third groove 151B, and portions 1511, 1512 of the first arm 151 forming the third groove 151B may be inserted into the upper groove 161U and the lower groove 161L. A first shaft 161P may penetrate the parts 1611, 1612, 1613 and the portions 1511, 1512 of the first arm 151. The first side frame 161 may be coupled to the first arm 151 so as to be rotatable about the first shaft 161P. The first side frame 161 may be rotated in response to the movement of the first arm 151.

A second holder 1620 may protrude from the second side frame 162 toward the second arm 152. The second holder 1620 may be formed at a central portion of the left side of the second side frame 162. The second holder 1620 may include parts 1621, 1622, 1623 that are spaced apart from each other. An upper groove 162U may be formed between an upper part 1621 and a middle part 1622. A lower groove 162L may be formed between the middle part 1622 and a lower part 1623. A fourth groove 152B may be formed at the other end of the second arm 152. The middle part 1622 may be inserted into the fourth groove 152B, and portions 1521, 1522 of the second arm 152 forming the fourth groove 152B may be inserted into the upper groove 162U and the lower groove 162L. A second shaft 162P may penetrate the parts 1621, 1622, 1623 and the portions 1521, 1522 of the second arm 152. The second side frame 162 may be coupled to the second arm 152 so as to be rotatable about the second shaft 162P. The second side frame 162 may be rotated in response to the movement of the second arm 152.

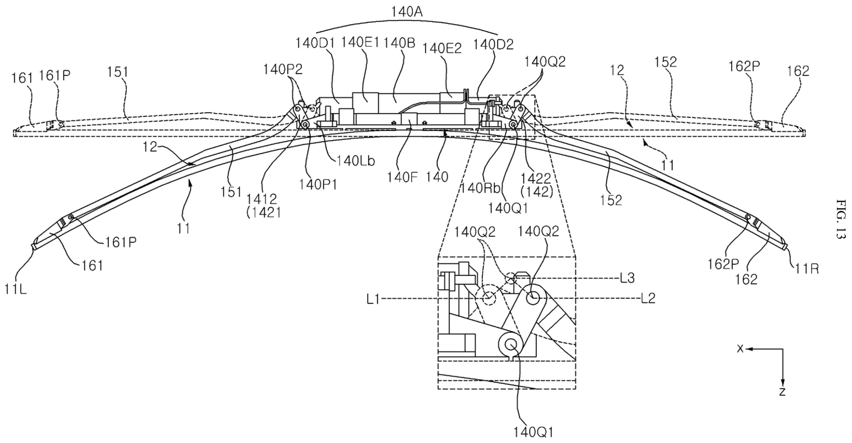

Referring to FIG. 13 together with FIG. 11, in response to the driving of the actuator 140A, the links 141, 142 and the arms 151, 152 may be rotated. The rotation shaft of the motor 140B of the actuator 140A may be rotated in a first rotation direction or a second rotation direction opposite to the first rotation direction. The rods 140C1, 140C2 of the actuator 140A may push or pull the links 141, 142.

In response to the rotation of the rotation shaft of the motor 140B in the first rotation direction, the first rod 140C1 may move to the left, and the second rod 140C2 may move to the right. The first link 141 may be rotated counterclockwise by the first rod 140C1 moving to the left, and the first arm 151 connecting the first link 141 and the first side frame 161 may also be rotated counterclockwise. The second link 142 may be rotated clockwise by the second rod 140C2 moving to the right, and the second arm 152 connecting the second link 142 and the second side frame 162 may also be rotated clockwise. Accordingly, the left side 11L and the right side 11R of the display panel 11 may move in a forward direction. As the driving time of the motor 140B increases, the curvature of the display panel 11 may decrease.

In response to the rotation of the rotation shaft of the motor 140B in the second rotation direction, the first rod 140C1 may move to the right, and the second rod 140C2 may move to the left. The first link 141 may be rotated clockwise by the first rod 140C1 moving to the right, and the first arm 151 connecting the first link 141 and the first side frame 161 may also be rotated clockwise. The second link 142 may be rotated counterclockwise by the second rod 140C2 moving to the left, and the second arm 152 connecting the second link 142 and the second side frame 162 may also be rotated counterclockwise. Accordingly, the left side 11L and the right side 11R of the display panel 11 may move in a rearward direction. As the driving time of the motor 140B increases, the curvature of the display panel 11 may decrease.

The links 141, 142 may pivot around the front shafts 140P1, 140Q1. The rear shafts 140P2, 140Q2 connecting the rods 140C1, 140C2 and the links 141, 142 may draw a circular trajectory with respect to the front shafts 140P1, 140Q1. When the display panel 11 and the plate 12 are flat, the rear shafts 140P2, 140Q2 and the rods 140C1, 140C2 may be positioned at a first level L1. When the display panel 11 and the plate 12 are bent to the maximum, the rear shafts 140P2, 140Q2 and the rods 140C1, 140C2 may be positioned at a second level L2. When the display panel 11 and the plate 12 are bent at a specific curvature that is smaller than the maximum curvature, the rear shafts 140P2, 140Q2 and the rods 140C1, 140C2 may be positioned at a third level L3. With respect to the frame 140, the third level L3 may be positioned higher than the first level L1 and the second level L2. With respect to the frame 140, the first level L1 and the second level L2 may be positioned at the same height. When the rear shafts 140P2, 140Q2 are positioned at the third level L3, the wings 1411, 1412, 1421, 1422 of the links 141, 142 may be perpendicular to the frame 140.

Accordingly, in response to the driving of the actuator 140A, the height of the actuator 140A having the rods 140C1, 140C2 connected to the rear shafts 140P2, 140Q2 may be changed. Specifically, as the position of the rods 140C1, 140C2 moves from the first level L1 to the second level L2, the actuator 140A may be moved in a rearward direction from the frame 140. As the position of the rods 140C1, 140C2 moves from the second level L2 to the third level L3, the actuator 140A may move toward the frame 140. The actuator 140A having the rods 140C1, 140C2 positioned at the second level L2 may be lifted from the frame 140. That is, the actuator 140A may be driven while being lifted, so that vibration and noise of the actuator 140A may be minimized.

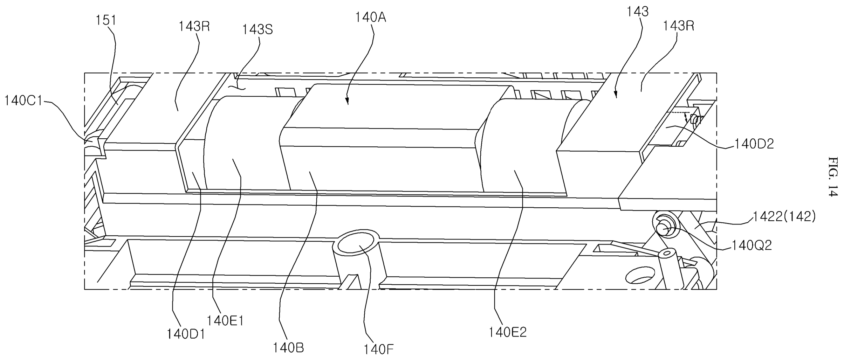

Referring to FIG. 14, the cover 143 may cover the rear of the actuator 140A and may be coupled to the frame 140. The actuator 140A may be positioned in the internal space 143S of the cover 143. The rear part 143R of the cover 143 may form the rear surface of the cover 143, and may form the rear boundary of the internal space 143S. The rear part 143R may be adjacent to the rear surface of the actuator 140A but spaced apart from it. The distance Dr between the rear surface of the actuator 140A and the front surface of the rear part 143R may vary depending on the height change of the actuator 140A with respect to the frame 140, and the minimum value of the distance Dr may be greater than 0.

Accordingly, the actuator 140A that is raised in a rearward direction from the frame 140 or is lowered toward the frame 140 may not be interfered with by the cover 143.

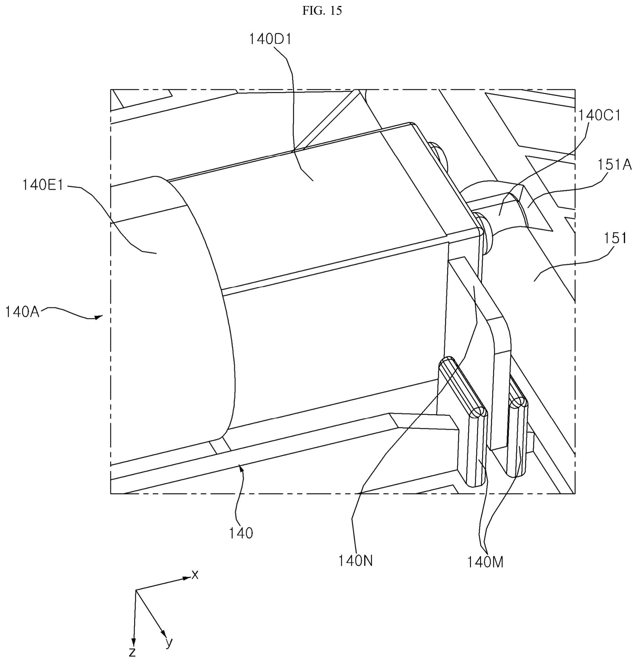

Referring to FIG. 15, a pair of ribs 140M may protrude from the rear surface of the frame 140, and may be adjacent to the first housing 140D1. The pair of ribs 140M may be spaced apart from each other in the movement direction of the first rod 140C1.

A flange 140N may protrude from the side surface of the first housing 140D1, and may be inserted into between the pair of ribs 140M.

Accordingly, in the movement direction of the first rod 140C1, i.e., in the horizontal direction, the movement of the actuator 140A may be restricted as the flange 140N is engaged with the ribs 140M. In addition, in the front-rear direction, the ribs 140M may guide the rising or falling of the actuator 140A with respect to the frame 140.

Referring again to FIG. 11, a sensor S may be coupled to the rear of the frame 140. The sensor S may be coupled to the inside of the cover 143 (see FIG. 14). A first sensor S1 may be adjacent to the first link 141. The first sensor S1 may be spaced in a rearward direction from the rear surface of the frame 140 by a certain distance. A second sensor S2 may be adjacent to the second link 142. The second sensor S2 may be positioned closer to the rear surface of the frame 140 than the first sensor S1.

For example, the sensor S may be a photo sensor. The sensor S may have an overall horseshoe shape. The sensor S may include a light emitting portion Sa and a light receiving portion Sb that are spaced apart from each other. The light emitting portion Sa may output light in an infrared wavelength range toward the light receiving portion Sb, and the light receiving portion Sb may detect the light from the light emitting portion Sa. If an object exists between the light emitting portion Sa and the light receiving portion Sb, the light from the light emitting portion Sa may not reach the light receiving portion Sb, so that the sensor S may detect the object.

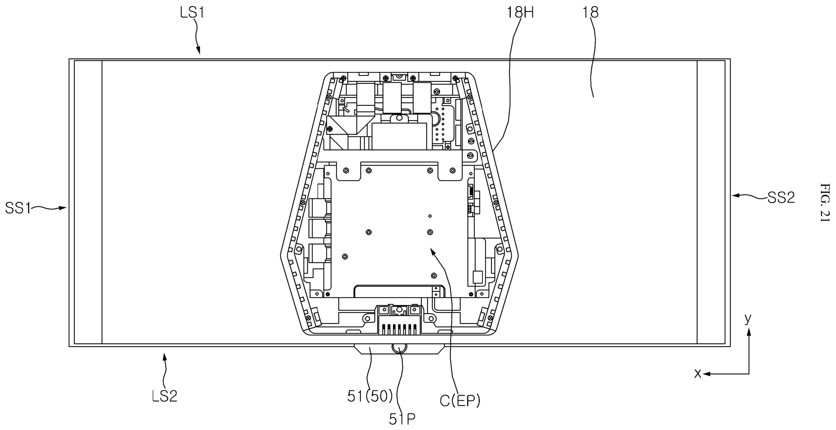

A first protrusion 1413 may protrude from at least one of the first wings 1411, 1412 of the first link 141. The first protrusion 1413 may extend in a direction intersecting with the first wing 1411. In response to the rotation of the first link 141, the first protrusion 1413 may draw a circular trajectory, and the circular trajectory may pass through a space between the light emitting portion Sa and the light receiving portion Sb of the first sensor S1. When the display panel 11 and the plate 12 are bent to the maximum curvature (see the solid line in FIG. 13), the first protrusion 1413 may be positioned between the light emitting portion Sa and the light receiving portion Sb, and the first sensor S1 may detect the first protrusion 1413. Accordingly, the first sensor S1 may detect whether the display panel 11 and the plate 12 are bent to the maximum curvature. When the display panel 11 and the plate 12 are bent to the maximum curvature (see the solid line in FIG. 13), a control unit C (see FIG. 21) electrically connected to the first sensor S1 through a first cable Ca may stop the operation of the actuator 140A that is operated to bend the display panel 11 and the plate 12.

A second protrusion 1423 may protrude from at least one of the second wings 1421, 1422 of the second link 142. The second protrusion 1423 may extend in a direction intersecting with the second wing 1421. In response to the rotation of the second link 142, the second protrusion 1423 may draw a circular trajectory, and the circular trajectory may pass through a space between the light emitting portion Sa and the light receiving portion Sb of the second sensor S2. When the display panel 11 and the plate 12 are flattened (see the dotted line in FIG. 13), the second protrusion 1423 may be positioned between the light emitting portion Sa and the light receiving portion Sb, and the second sensor S2 may detect the second protrusion 1423. Accordingly, the second sensor S2 may detect whether the display panel 11 and the plate 12 are flattened. When the display panel 11 and the plate 12 are flattened (see the dotted line in FIG. 13), the control unit C (see FIG. 21) electrically connected to the second sensor S2 through a second cable Cb may stop the operation of the actuator 140A that is operated to flatten the display panel 11 and the plate 12.

For example, a first angle between the first protrusion 1413 and the first wing 1411 may be the same as a second angle between the second protrusion 1423 and the second wing 1421.

Meanwhile, in addition to the first sensor S1 and the second sensor S2, a third sensor S3 (not shown) may be positioned in the first link 141 or the second link 142. The third sensor S3 may be positioned closer to the rear surface of the frame 140 than the first sensor S1, but positioned further from the rear surface of the frame 140 than the second sensor S2. In this case, a third protrusion 1414, 1424 may extend from the first wing 1412 or the second wing 1422, and the third sensor S3 may detect the third protrusion 1414, 1424. For example, a third angle between the third protrusion 1414, 1424 and the wing 1412, 1422 may be equal to the first angle. Accordingly, the third sensor S3 may detect whether the display panel 11 and the plate 12 are bent at a specific curvature that is less than the maximum curvature.

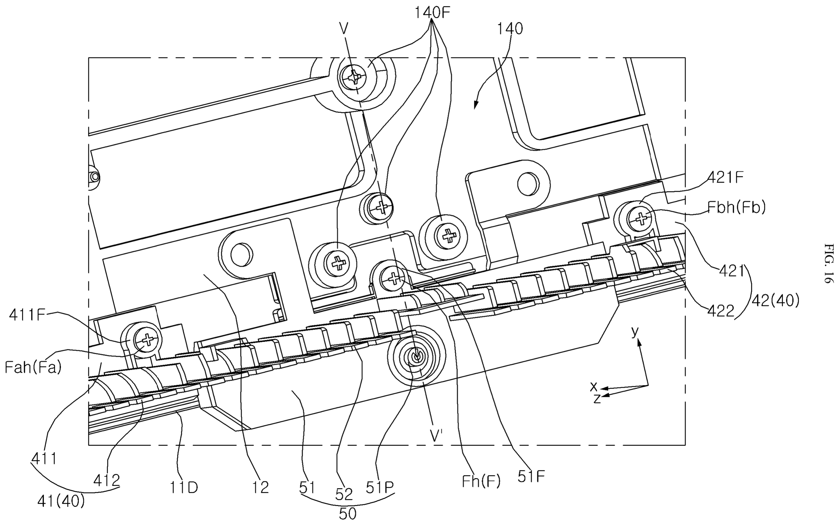

Referring to FIGS. 16 to 18, a controller 50 may be adjacent to the lower side 11D of the display panel 11. The controller 50 may be arranged in the central portion of the lower side 11D. The controller 50 may include a housing 51 and fins 52.

The housing 51 may be positioned at the rear of the display panel 11. The housing 51 may be extended horizontally. The housing 51 may protrude downward from the lower side 11D of the display panel 11. A fixing portion 51F may protrude from the upper side of the housing 51. A fixing pin 12F may protrude from the rear surface of the plate 12, and may be inserted into the fixing portion 51F. The fixing pin 12F may be positioned in the vertical line VV'. The outer diameter of the fixing pin 12F may be substantially the same as the diameter of the hole of the fixing portion 51F into which the fixing pin 12F is inserted. A fastening member F such as a screw may be fastened to the fixing pin 12F, and the rear surface of the fixing portion 51F may be engaged with the head Fh of the fastening member F. Accordingly, the housing 51 may be fixed to the plate 12.

A button 51P may be mounted on the rear surface of the housing 51. A user may press the button 51P to turn on the display 10. The button 51P may be a joystick, and a user may control the display 10 by operating the button 51P. An antenna may also be mounted in the internal space of the housing 51.

The fins 52 may protrude from the rear surface of the housing 51. The fins 52 may be arranged in the length direction (i.e., left-right direction) of the housing 51. The fins 52 may be spaced apart from each other. A vent hole may be formed between the fins 52.

Referring again to FIG. 16, a bottom grille 40 may be arranged along the lower side 11D of the display panel 11. The bottom grille 40 may be referred to as a bottom vent member 40. The bottom grille 40 may include a first bottom grille 41 and a second bottom grille 42. The controller 50 may be arranged between the first bottom grille 41 and the second bottom grille 42. The bottom grille 40 may be referred to as a second grille 40. The second grille 40 may be flexible.

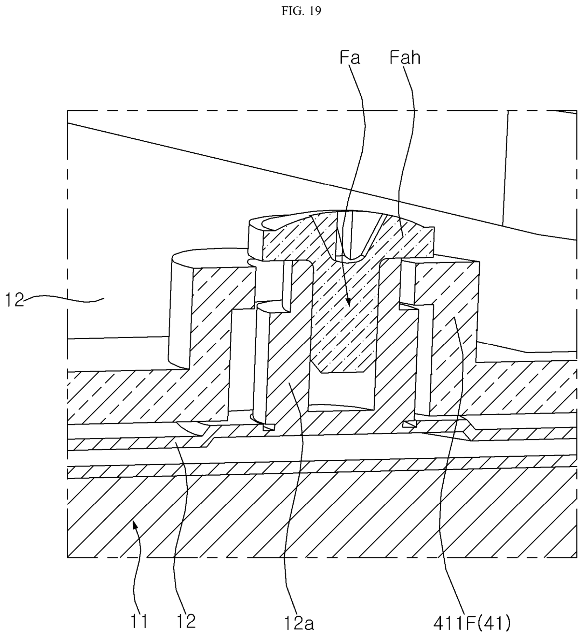

Referring to FIG. 19 together with FIG. 16, the first bottom grille 41 may be positioned at the rear of the display panel 11. The first bottom grille 41 may extend along the lower side 11D of the display panel 11. The first bottom grille 41 may include a body 411 and fins 412.

The body 411 may be adjacent to the lower side 11D of the display panel 11 and may extend along the lower side 11D. A coupling pin 12a may protrude from the rear surface of the plate 12, and may be inserted into a coupling portion 411F of the body 411. The coupling pin 12a may be spaced to the left from the vertical line VV'. The outer diameter of the coupling pin 12a may be smaller than the diameter of the hole 411Fh of the coupling portion 411F into which the coupling pin 12a is inserted. A fastening member Fa such as a screw may be fastened to the coupling pin 12a, and the rear surface of the coupling portion 411F may be engaged with the head Fah of the fastening member Fa.

Accordingly, the body 411 may be coupled to the rear of the plate 12. If the plate 12 is flat (see the dotted line in FIG. 13), the coupling pin 12a may be positioned biased to the right of the central portion of the hole 411Fh. As the plate 12 is bent see (solid line in FIG. 13), the coupling pin 12a may be moved to the left within the hole 411Fh. That is, in response to the change in curvature of the plate 12, the plate 12 may slip with respect to the body 411.

The pins 412 may protrude from the rear surface of the body 411. The pins 412 may be arranged in the length direction (i.e., left-right direction) of the body 411. The pins 412 may be spaced apart from each other. A vent hole may be formed between the pins 412.

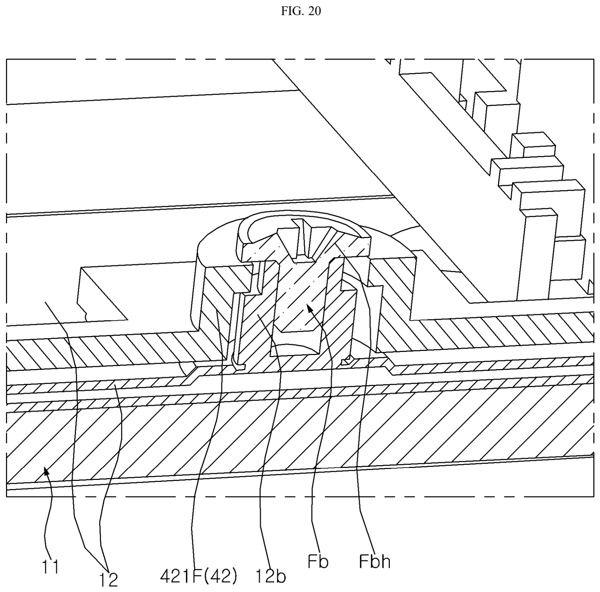

Referring to FIG. 20 together with FIG. 16, the second bottom grille 42 may be positioned at the rear of the display panel 11. The second bottom grille 42 may extend along the lower side 11D of the display panel 11. The second bottom grille 42 may include a body 421 and fins 422.

The body 421 may be adjacent to the lower side 11D of the display panel 11 and may extend along the lower side 11D. A coupling pin 12b may protrude from the rear surface of the plate 12, and may be inserted into a coupling portion 421F of the body 421. The coupling pin 12b may be spaced to the right from the vertical line VV'. The outer diameter of the coupling pin 12b may be smaller than the diameter of the hole 421Fh of the coupling portion 421F into which the coupling pin 12b is inserted. A fastening member Fb, such as a screw, may be fastened to the coupling pin 12b, and the rear surface of the coupling portion 421F may be engaged with the head Fbh of the fastening member Fb.

Accordingly, the body 421 may be coupled to the rear of the plate 12. If the plate 12 is flat (see the dotted line in FIG. 13), the coupling pin 12b may be positioned biased to the left of the central portion of the hole 421Fh. As the plate 12 is bent (see the solid line in FIG. 13), the coupling pin 12b may move to the right within the hole 421Fh. That is, in response to the change in curvature of the plate 12, the plate 12 may slip with respect to the body 421.

Fins 422 may protrude from the rear surface of the body 421. The fins 422 may be arranged in the length direction (i.e., left-right direction) of the body 421. The fins 422 may be spaced apart from each other. A vent hole may be formed between the fins 422.

Referring again to FIG. 1, a top grille 30 may be arranged along the upper side of the display panel 11. The top grille 30 may be adjacent to the upper side of the display panel 11 and coupled to the rear of the plate 12 (see FIG. 13). The top grille 30 may be opposite to a bottom grille 40 (see FIG. 16). The top grille 30 may be referred to as a top vent member 30. The top grille 30 may have a shape identical to or corresponding to that of the bottom grille 40. Fins 32 of the top grille 30 may intersect with the display panel 11, and may be arranged along the upper side of the display panel 11. A vent hole may be formed between the fins 32. The top grille 30 may be referred to as a first grille 30. The first grille 30 may be flexible.

Accordingly, the internal space of the display 10 may be communicated with the outside of the display 10 through a gap between the fins 32 of the top grille 30, a gap (see FIG. 16) between the fins 412, 422 of the bottom grille 40, and a gap (see FIG. 16) between the fins 52 of the controller 50. The heat of the display 10 may be dissipated to the outside by air passing through the gaps.

The fins 32, 412, 422, 52 may form a parabolic curve convex toward the rear. The height at which the fins 32, 412, 422, 52 protrude in a rearward direction from the plate 12 (see FIG. 3) may gradually decrease from the central portion of the fins 32, 412, 422, 52 to the outer edge of the fins 32, 412, 422, 52. The upper side of a back cover 18 may extend along the fins 32. The lower side of the back cover 18 may extend along the fins 412, 422, 52. The left side of the back cover 18 may extend in a straight line, and may be positioned on the first side frame 161 (see FIG. 13). The right side of the back cover 18 may extend in a straight line, and may be positioned on the second side frame 162 (see FIG. 13).

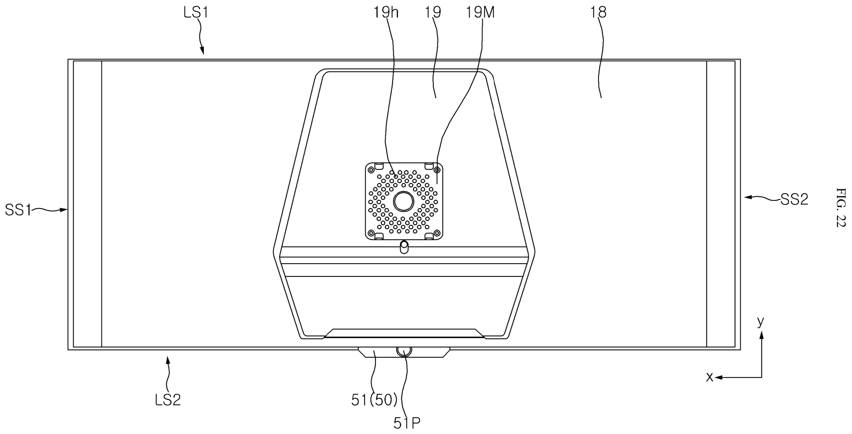

Referring to FIGS. 21 and 22, the back cover 18 may cover the rear of the plate 12 (see FIG. 3). The back cover 18 may cover components coupled to the rear of the plate 12, such as the driving module 14, the arms 151, 152, and the side frames 161, 162. Fins 32, 412, 422, 52 (see FIGS. 1 and 16) may be positioned between the plate 12 and the back cover 18. The back cover 18 may be curved along the fins 32, 412, 422, 52 (see FIG. 1). The back cover 18 may be flexible. The back cover 18 may be bent or flattened together with the display panel 11 and the plate 12.

A hole 18H may be formed in the central portion of the back cover 18. For example, the hole 18H may have a hexagonal shape. Electronic components EP may be positioned inside the hole 18H, and may be coupled to the rear of the plate 12 (see FIG. 3).

A central cover 19 may cover the hole 18H, and may be coupled to the back cover 18. Holes 19h may be formed in the central cover 19. Mount 19M may be formed in the central portion of the central cover 19, and may have the holes 19h. The column 4 (see FIG. 1) of the stand 2 may be mounted on the mount 19M.

Referring to FIGS. 1 to 22, according to one aspect of the present disclosure, the display device (1) may include: a flexible display panel (11); a flexible plate (12) which is positioned at a rear of the display panel (11), and to which the display panel (11) is coupled; a first side frame (161) which is adjacent to a first side of the plate (12) and which is coupled to a rear of the plate (12); a second side frame (162) which is adjacent to a second side of the plate (12) opposite to the first side of the plate (12) and which is coupled to the rear of the plate (12); a first arm (151) which extends in a direction intersecting with the first side of the plate (12), and which is rotatably coupled to the first side frame (161); a second arm (152) which extends in a direction intersecting with the second side of the plate (12), and which is rotatably coupled to the second side frame (162); and a driving module (14) which is positioned between the first arm (151) and the second arm (152), and which rotates the first arm (151) and the second arm (152).

The driving module (14) may include: a frame (140) which is coupled to the rear of the plate (12); an actuator (140A) which includes a first rod (140C1) and a second rod (140C2) that move in opposite directions, and which is positioned at a rear of the frame (140); a first link (141) which connects the first arm (151) to the frame (140), and which is rotatably coupled to the first arm (151) and the frame (140); and a second link (142) which connects the second arm (152) to the frame (140), and which is rotatably coupled to the second arm (152) and the frame (140), in which the first rod (140C1) may push or may pull the first arm (151), in response to a driving of the actuator (140A), and the second rod (140C2) may push or may pull the second arm (152), in response to the driving of the actuator (140A).

The driving module (14) may further include: a first front shaft (140P1) penetrating the first link (141) and the frame (140); and a first rear shaft (140P2) penetrating the first link 9141), the first arm (151), and the first rod (140C1).

The first link (141) may include: a first link base (1410) rotatably coupled to the frame (140); and a pair of first wings (1411, 1412) intersecting with the first link base (1410). The first arm (151) may include a first groove (151A) in which the first rod (140C1) is positioned, may be positioned between the pair of first wings (1411, 1412), and may be rotatably coupled to the first rod (140C1) and the pair of first wings (1411, 1412).

The pair of first wings (1411, 1412) may rotate with respect to the frame (140) and may draw a circular trajectory.

The actuator (140A) may move in a direction away from or toward the frame (140), in response to the driving of the actuator (140A).

The actuator (140A) may be positioned farthest in a rearward direction from the frame (140), when the display panel (11) is bent at a specific curvature less than a maximum curvature.

The driving module (14) may further include: a pair of ribs (140M) which protrude from a rear surface of the frame (140), and which are spaced apart from each other in a direction of movement of the first rod (140C1); and a flange (140N) which protrudes from a side surface of the actuator (140A), and which is inserted into between the pair of ribs (140M).

The actuator (140A) may include: a motor (140B); a first reducer (140E1) between the first rod (140C1) and the motor (140B); and a second reducer (140E2) between the second rod (140C2) and the motor (140B).

The display device (1) may further include a sensor (S) adjacent to the first wing (1411) of the first link (141). The first link (141) may further include a first protrusion (1413) which protrudes from the first wing (1411) and which intersects with the first wing (1411), and the sensor (S) may detect the first protrusion (1413).

The sensor (S) may include a light emitting portion (Sa) and a light receiving portion (Sb) which are spaced apart from each other, and when the first protrusion (1413) is positioned between the light emitting portion (Sa) and the light receiving portion (Sb), the sensor (S) may detect the first protrusion (1413).

The first protrusion (1413) may be detected by the sensor (S), when the display panel (11) is bent at a maximum curvature, or when the display panel (11) is flat.

The frame (140) may be positioned on a vertical line (VV') passing through a center of the plate (12), and a point at which the frame (140) is fixed to the plate (12) may be positioned on the vertical line (VV'), or may be positioned less than a certain distance from the vertical line (VV').

The driving module (14) may be symmetrical with respect to the vertical line (VV').

The display device (1) may further include: a first shaft (161P) which penetrates the first side frame (161) and the first arm, (151) and which provides a rotation axis of the first arm (151); and a second shaft (162P) which penetrates the second side frame (162) and the second arm (152), and which provides a rotation axis of the second arm (152).

The plate (12) may be slidable with respect to the display panel (11).

The display device (1) may further include a first side pin (111) which is adjacent to the first side frame (161) and which protrudes in a rearward direction from the display panel (11). The plate (12) may include a first rear slot (121S) into which the first side pin (111) is movably inserted, and a rear surface of the plate (12) may be engaged with a head of the first side pin (111).

The display device (1) may further include a controller (50) which is positioned on a vertical line (VV') passing through a center of the plate (12), and which is adjacent to a lower side of the plate (12), and which is coupled to the rear of the plate (12); a first bottom grille (41) which is positioned between the first side of the plate (12) and the controller (50), and which is slidable with respect to the plate (12); and a second bottom grille (42) which is positioned between the second side of the plate (12) and the controller (50), and which is slidable with respect to the plate (12), in which a portion of the controller (50) may protrude downwardly from the lower side of the plate (12).

According to another aspect of the present disclosure, a display device (1) may include: a flexible plate (12); a flexible display panel (11) coupled to the flexible plate (12); a first side frame (161) coupled to a rear first side of the flexible plate (12); a second side frame (162) coupled to a rear second side of the flexible plate (12); a center frame (140) coupled to the flexible plate (12) between the first side frame (161) and the second side frame (162); a first arm (151) extending from the center frame (140) to the first side frame (161), and rotatably coupled to the first side frame (161); a second arm (152) extending from the center frame (140) to the second side frame (162), and rotatably coupled to the second side frame (162); and a driving module (14) on the center frame (140) and configured to actuate slidable and moveable first and second rods (140C1, 140C2) in and out to slidably extend and retract the first arm (151) and the second arm (152), respectively.

The driving module (14) may include: an actuator (140A) including the first rod (140C1) and the second rod (140C2) that move in opposite directions to extend and retract the first arm (151) and the second arm (152); a first link (141) connecting the first arm (151) to the center frame (140), and rotatably coupled to the first arm (151) and the center frame (140); and a second link (142) connecting the second arm (152) to the center frame (140), and rotatably coupled to the second arm (152) and the center frame (140), and wherein the first link (141) and the second link (142) may be rotatable away from the center frame (140) in response to the driving module (14) slidably retracting the first and second arms (151, 152) and flexibly curving the flexible plate (12), and the first link (141) and the second link (142) may be rotatable toward the center frame (140) to slidably extend the first and second arms (151, 152) and uncurve the flexible plate (12).

The first link (141) may include first and second through holes for connection to the center frame (140) and the first arm (151), wherein the second link (142) may include first and second through holes for connection to the center frame (140) and the second arm (152), wherein the first link may be connected to the center frame (140) and the first arm (151) via a first rotatable shaft inserted through the first through hole of the first link (141), and wherein the second link (142) may be connected to the center frame (140) and the second arm (152) via a second rotatable shaft inserted through the first through hole of the second link (142).

The actuator (140A) may be moveable disposed within the driving module (14).

According to another aspect of the present disclosure, a display device (1) may include: a flexible display panel (11); a flexible plate (12) which is positioned at a rear of the display panel (11), and to which the display panel (11) is coupled; a driving module (14) which is positioned at a rear of the plate (12); a first arm (151) which includes one side rotatably coupled to the driving module (14), and which includes the other side that is adjacent to a first side of the plate (12) and rotatably coupled to the plate (12); and a second arm (152) which includes one side rotatably coupled to the driving module (14), and which includes the other side that is adjacent to a second side of the plate (12) opposite to the first side of the plate (12) and rotatably coupled to the plate (12).

According to another aspect of the present disclosure, a display device (1) may include: a flexible display panel (11); a flexible plate (12) which is positioned at a rear of the display panel (11), and to which the display panel (11) is coupled; a driving module (14) which is positioned at a rear of the plate (12); a first arm (151) which extends in a direction intersecting with a first side of the plate (12), and which receives power from the driving module (14) to push the first side in a forward direction or to pull the first side in a rearward direction; and a second arm (152) which extends in a direction intersecting with a second side of the plate (12) opposite to the first side of the plate (12), and which receives power from the driving module (14) to push the second side in a forward direction or to pull the second side in a rearward direction.

The effects of the display device according to the present disclosure are described as follows.

According to at least one of the embodiments of the present disclosure, a structure that can freely change the curvature of a display panel can be provided.

According to at least one of the embodiments of the present disclosure, a mechanism that can freely change the curvature of a display panel can be provided.

According to at least one of the embodiments of the present disclosure, a structure for synchronizing the rotation of arms that bend or unfold a display panel can be provided.

According to at least one of the embodiments of the present disclosure, a structure for pushing or pulling arms while an actuator is lifted can be provided.

According to at least one of the embodiments of the present disclosure, a structure for minimizing vibration and noise of an actuator can be provided.

Certain embodiments or other embodiments of the invention described above are not mutually exclusive or distinct from each other. Any or all elements of the embodiments of the invention described above may be combined or combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except in the case where it is described that the combination is impossible.

The foregoing embodiments are merely examples and are not to be considered as limiting the present disclosure. The scope of the present disclosure should be determined by rational interpretation of the appended claims, and all modifications within the equivalents of the disclosure are intended to be included within the scope of the present disclosure.

## Claims

1. A display device (1) comprising:
a flexible plate (12);
a flexible display panel (11) coupled to the flexible plate (12);
a first side frame (161) coupled to a rear first side of the flexible plate (12);
a second side frame (162) coupled to a rear second side of the flexible plate (12);
a center frame (140) coupled to the flexible plate (12) between the first side frame (161) and the second side frame (162);
a first arm (151) extending from the center frame (140) to the first side frame (161), and rotatably coupled to the first side frame (161);
a second arm (152) extending from the center frame (140) to the second side frame (162), and rotatably coupled to the second side frame (162); and
a driving module (14) on the center frame (140) and configured to actuate slidable and moveable first and second rods (140C1, 140C2) in and out to slidably extend and retract the first arm (151) and the second arm (152), respectively.

2. The display device (1) of claim 1, wherein the driving module (14) comprises:
an actuator (140A) including the first rod (140C1) and the second rod (140C2) that move in opposite directions to extend and retract the first arm (151) and the second arm (152);
a first link (141) connecting the first arm (151) to the center frame (140), and rotatably coupled to the first arm (151) and the center frame (140); and
a second link (142) connecting the second arm (152) to the center frame (140), and rotatably coupled to the second arm (152) and the center frame (140), and
wherein the first link (141) and the second link (142) are rotatable away from the center frame (140) in response to the driving module (14) slidably retracting the first and second arms (151, 152) and flexibly curving the flexible plate (12), and the first link (141) and the second link (142) are rotatable toward the center frame (140) to slidably extend the first and second arms (151, 152) and uncurve the flexible plate (12).

3. The display device (1) of claim 2, wherein the driving module (14) further comprises:
a first front shaft (140P1) penetrating the first link (141) and the center frame (140); and
a first rear shaft (140P2) penetrating the first link (141), the first arm (151), and the first rod (140C1).

4. The display device (1) of claim 2 or 3, wherein the first link (141) comprises:
a first link base (1410) rotatably coupled to the center frame (140); and
a pair of first wings (1411, 1412) intersecting with the first link base (1410), and
wherein the first arm (151) comprises a first groove (151A) receiving the first rod (140C1), and positioned between the pair of first wings (1411, 1412), and is rotatably coupled to the first rod (140C1) and the pair of first wings (1411, 1412) to extend and retract the first arm (151) and the second arm (152).

5. The display device (1) of claim 4, wherein the pair of first wings (1411, 1412) rotate with respect to the center frame (140) and draw a circular trajectory.

6. The display device (1) of any one of claims 2 to 5, wherein the actuator (140A) moves the first rod (140C1) and the second rod (140C2) in a direction away from or toward the first side frame (161) and the second side frame (162), respectively, in response to a driving of the actuator (140A).

7. The display device (1) of any one of claims 2 to 6, wherein the actuator (140A) is positioned farthest in a rearward direction from the center frame (140), when the flexible display panel (11) is bent at a specific curvature less than a maximum curvature.

8. The display device (1) of any one of claims 2 to 7, wherein the driving module (14) further comprises:
a pair of ribs (140M) protruding from a rear surface of the center frame (140), and spaced apart from each other in a direction of movement of the first rod (140C1); and
a flange (140N) protruding from a side surface of the actuator (140A), and inserted into between the pair of ribs (140M).

9. The display device (1) of any one of claims 2 to 8, wherein the actuator (140A) comprises:
a motor (140B);
a first reducer (140E1) between the first rod (140C1) and the motor (140B); and
a second reducer (140E2) between the second rod (140C2) and the motor (140B).

10. The display device (1) any one of claims 4 to 9, further comprising:
a sensor (S) adjacent to the first wing (1411) of the first link (141),
wherein the first link (141) further comprises a first protrusion (1413) protruding from the first wing (1411) and intersecting with the first wing (1411), and
wherein the sensor (S) detects the first protrusion (1413).

11. The display device (1) of claim 10, wherein the sensor (S) comprises a light emitting portion (Sa) and a light receiving portion (Sb) spaced apart from each other, and
wherein, when the first protrusion (1413) is positioned between the light emitting portion (Sa) and the light receiving portion (Sb), the sensor (S) detects the first protrusion (1413).

12. The display device (1) of claim 10 or 11, wherein the first protrusion (1413) is detected by the sensor (S), when the flexible display panel (11) is bent at a maximum curvature, or when the flexible display panel (11) is flat.

13. The display device (1) of any one of claims 1 to 12, wherein the center frame (140) is positioned on a vertical line (VV') passing through a center of the flexible plate (12), and
wherein a point at which the center frame (140) is fixed to the flexible plate (12) is positioned on the vertical line (VV'), or is positioned less than a certain distance from the vertical line (VV').

14. The display device (1) of claim 13, wherein the driving module (14) is symmetrical with respect to the vertical line (VV').

15. The display device (1) of any one of claims 1 to 14, further comprising:
a first shaft (161P) penetrating the first side frame (161) and the first arm (151), and providing a rotation axis of the first arm (151); and
a second shaft (162P) penetrating the second side frame (162) and the second arm (152), and providing a rotation axis of the second arm (152).
